# EUROPEAN PATENT APPLICATION

(11) **EP 4 415 259 A1**
(43) Date of publication of application: **14.08.2024**
(21) Application number: 23305173.9
(22) Date of filing: 09.02.2023
(51) Int. Cl.: H03F 3/24, H03F 3/30, H03F 3/45, H04B 5/00, H03F 1/02

(54) **METHOD FOR CONTROLLING AN ENVELOPE SHAPE OF AN OUTPUT SIGNAL OUTPUTTED BY A DRIVER OF A WIRELESS TRANSMITTER, AND CORRESPONDING INTEGRATED CIRCUIT**

(71) Applicant: STMicroelectronics International N.V., 1228 Plan-les-Ouates, Geneva (CH)
(72) Inventor: SVETE, Tilen, 1215 Medvode (SI); MONTJAUX, Grégoire, 38640 Claix (FR)
(74) Representative: Casalonga

(57) **Abstract**

The method for controlling an envelope shape of an output signal (DRV_out) outputted by a driver (DRV) of a wireless transmitter (TX), includes:
- supplying a first voltage level (unmod_lvl) and a second voltage level (mod_lvl);
- generating a filtered envelope reference signal (rf_lvl) by switching between the first voltage level (unmod_lvl) and the second voltage level (mod_lvl), in conjunction with low-pass filtering the transitions between the first voltage level (unmod_lvl) and the second voltage level (mod_lvl);
- generating a driver supply voltage (VDD_RF) following the filtered envelope reference signal (rf_lvl), regulated in a manner adapted to supply the driver (DRV);
- controlling the envelope shape of the output signal (DRV_out) by supplying the driver (DRV) with the driver supply voltage (VDD_RF).

## Description

Embodiments are related to integrated circuits, in particular an integrated circuit including a wireless transmitter comprising a driver for controlling a signal envelope shape of a modulation pulse.

RFID ("Radio Frequency Identification") and NFC ("Near Field Communication") standards specify the modulation shapes (rising edge, falling edge, overshoots, undershoots and non-monotonicity of the edges) of the transmission device (called a RFID reader, or NFC poller).

RFID and NFC systems are magnetically coupled systems, where the presence of a receiver antenna influences the parameters of the transmitter antenna. This is usually referred to as "loading effect". The loading effect (magnetic coupling) can detune the transmitter antenna which then usually leads to distortion of the modulation shapes. Know effect are overshoot following the rising edge of the modulation pulse, or undershoot following the falling edge of a modulation pulse.

RFID and NFC systems are defined by ISO14443 standard and ISO15693 standard. FeliCa protocol, also called NFC-F technology, is standardized in JIS.X.6319.

In latest specifications of EMVCo (specifications for contactless credit card payment), NFC Forum (organization concerning NFC systems) and aforementioned standards, transmitted RF field modulation pulse shape requirements are becoming more stringent, thus making active wave shaping "AWS" an almost mandatory feature of all reader and writer NFC products.

Not using AWS means that the RF field envelope can in certain conditions exhibit overshoots and undershoots during modulation pulses, and hence failing in certification.

A state-of-the-art solution implementing AWS using two voltage regulators with different functions has been proposed. In such a solution, the modulation shape is generated through switching between an unmodulated voltage level supplied by a first regulator, and a modulated voltage level supplied by a second regulator.

Hence, the two regulators implementation is effective but involves additional area, for the two regulators instead of one, and an increased driver area to support two supplies, and also additional pads for coupling large additional external capacitors.

Indeed, conventional regulators include a large external capacitor for stabilization and charge reservoir, usually in the range of 1 µF (microfarad) to 10 µF (microfarads). The external capacitors provided for the both regulators thus introduce a large additional footprint.

Therefore, it would be beneficial to provide solutions with smaller footprint and with less complexity, in order to reduce manufacturing costs (usually called "bill of materials"), together with improving performances.

According to an aspect, a method is proposed for controlling an envelope shape of an output signal outputted by a driver of a wireless transmitter, including:
- supplying a first voltage level and a second voltage level;
- generating a filtered envelope reference signal by switching between the first voltage level and the second voltage level, in conjunction with low-pass filtering the transitions between the first voltage level and the second voltage level;
- generating a driver supply voltage following the filtered envelope reference signal, regulated in a manner adapted to supply the driver;
- controlling the envelope shape of the output signal by supplying the driver with the driver supply voltage.

For instance, data are transmitted on the output signal through pulses of modulated amplitude of a carrier signal. In NFC wireless transmitters, the carrier signal may have a frequency of 13,56MHz.

Consequently, this method uses only one regulated voltage for supplying the driver, so the driver supply voltage can be generated by only one regulator circuit, hence providing a reduction in area and a simplified driver (indeed, there is thus no need to double the driver to accommodate two supply voltages).

This method also permits to reduce the bill of material because it does not require external capacitors for several regulators, and because the method allows to reduce the complexity of metal connections for supplying the driver with the only one driver supply voltage.

In addition, the method improves the modulation pulse shaping performance from the aforementioned prior solution, because there are no transitions between the two regulators, while transitions may disturb the antenna signal of the wireless transmitter.

According to an embodiment, the first voltage level sets the level of unmodulated pulses in the output signal, and the second voltage level sets the level of modulated pulses in the output signal.

Thus, controlling the first voltage level and the second voltage level permits to control the amplitude of the output signal in unmodulated pulses and in modulated pulses, for example according to desired value for desired performances.

According to an embodiment, the low-pass filtering is adapted so that the filtered envelope reference signal has a monotonic variation until a steady state at the first voltage level or at the second voltage level respectively to each transition.

In other words, a monotonic variation until a steady state may mean that the filtered envelope reference signal only increases from the lower level to the higher level, or only decreases from the higher level to the lower level, and does not surpass over nor under the respective steady state levels.

The low-pass filtering may indeed be configured in order to cause such monotonic variations which may cause an increase in the response time to reach the steady state, together with complying with specification regarding the response time.

According to an embodiment, the low pass filtering is responsive to control settings which controls independently a rising time constant and a falling time constant.

In other words, the low pass filtering may be optimized for each transition independently, for instance in order to cause or adjust the aforementioned monotonic variations, and to adjust the response time, depending on a desired data rate operations and/or a given antenna circuit.

Thus, a given implementation may be easily adapted to different performances and architectures applications.

According to another possible embodiment, the low pass filtering is an analog low pass filtering using a rising time constant equal to the falling time constant.

In other words, only one time constant maybe used for the falling edges and the rising edges.

According to an embodiment, regulating the driver supply voltage includes an output powering action adapted to drive up and to drive down the driver supply voltage, and an internal mirroring action adapted to reproduce of the output powering action for internal stabilization of the driver supply voltage with a capacitive and resistive feedback looping.

Such an advanced regulating of the driver supply voltage advantageously provides a high bandwidth response, a low noise supply voltage signal, a minimized short circuit current at the output, and an internal stabilization removing the need for a large external capacitor between the output voltage and a ground voltage. A small external capacitor may thus be designed in the range of 10 nF (nanofarad) to 100 nF (nanofarads), corresponding to about a hundredth of the typical capacitive value of external capacitors.

According to another aspect, it is proposed a wireless transmitter including:
- a driver configured to output an output signal with a controlled envelope shape;
- supplying circuits configured to supply a first voltage level and a second voltage level;
- a pulse shape filter circuit which, in order to generate a filtered envelope reference signal, is configured to switch between the first voltage level and the second voltage level, in conjunction with to low-pass filter the transitions between the first voltage level and the second voltage level;

- a regulator circuit configured to generate a driver supply voltage following the filtered envelope reference signal and adapted to supply the driver;
- the driver being configured to be supplied with the driver supply voltage such that the driver supply voltage controls the envelope shape of the output signal.

According to an embodiment, the driver is configured to output unmodulated pulses in the output signal having a level set by the first voltage level, and to output modulated pulses in the output signal having a level set by the second voltage level.

According to an embodiment, the pulse shape filter circuit is adapted to low-pass filter the filtered envelope reference signal to have a monotonic variation until a steady state at the first voltage level and at the second voltage level, respectively to each transition.

According to an embodiment, the pulse shape filter circuit is responsive to control settings which controls independently a rising time constant and a falling time constant for the low-pass filtering.

According to another possible embodiment, the pulse shape filter circuit includes an analog low pass filter having a rising time constant equal to a falling time constant.

According to an embodiment, the regulator circuit includes an output power stage configured to push up and to pull down the driver supply voltage, and an internal stabilizing circuit including a mirror stage configured to mirror the output power stage, and a capacitive and resistive feedback loop.

Other features and advantages of the present invention will appear when examining the following detailed description, only providing non-limiting example of embodiments, with reference to the annexed drawings in which:
[Fig.1] and
[Fig.2] and
[Fig.3] illustrate embodiments of the invention.

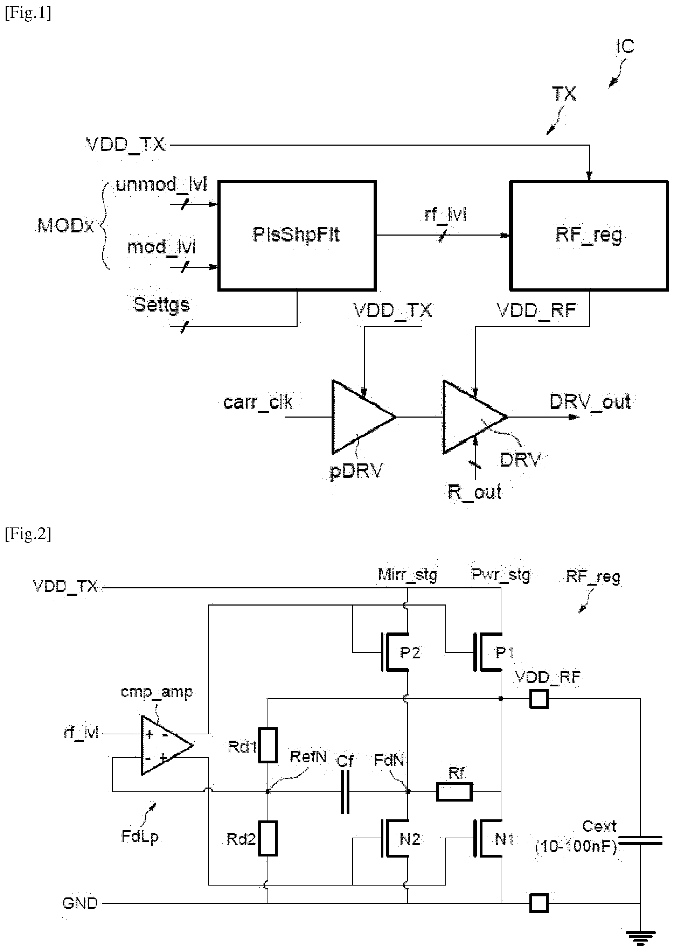

Figure 1 illustrates an integrated circuit CI comprising a wireless transmitter TX, for example configured to perform wireless communications such as "NFC" (which stands for "Near Field Communication"), and/or according to ISO14443 TypeA standard, and/or ISO14443 TypeB standard, and/or ISO15693 standard, and/or JIS.X.6319.

The wireless transmitter TX includes a supply voltage source line VDD_TX. The supply voltage VDD_TX may be an external unregulated or regulated supply voltage or an internal regulated supply voltage.

The wireless transmitter TX includes a driver DRV, for instance a D-class driver, configured to output an output signal DRV_out with a controlled envelope shape. The envelope shape is controlled by a driver supply voltage VDD_RF which supplies the driver DRV.

The output signal DRV_out may be directly applied to an antenna circuit (not shown) generating a magnetic field, for conveying strings of digital data according to successive pulses provided on the envelope shape of the output signal DRV_out.

The driver supply voltage VDD_RF is an internal regulated supply voltage driver DRV, as described hereinafter and advantageously supplied by the regulator depicted on Figure 2.

The driver supply voltage VDD_RF accordingly modulates the amplitude of a carrier clock signal carr_clk supporting the output signal DRV_out.

The carrier clock signal carr_clk may for instance be inputted to the driver circuit DRV through a pre-driver pDRV supplied by the supply voltage VDD_TX. The carrier clock signal carr_clk may be a sinusoid or a squared signal, and at a frequency of 13,56MHz in the NFC example.

The wireless transmitter TX also includes supplying circuits MODx configured to supply a first voltage level unmod_lvl and a second voltage level mod_lvl.

The first voltage level unmod_lvl may correspond to the unmodulated level of the driver output amplitude setting, and the second voltage level mod_lvl may correspond to the modulated level of the driver output amplitude setting.

In other words, the driver DRV may accordingly be configured to output unmodulated pulses in the output signal DRV_out having a level set by the first voltage level unmod_lvl, and to output modulated pulses in the output signal DRV_out having a level set by the second voltage level mod_lvl.

The first voltage level unmod_lvl and the second voltage level mod_lvl are inputted to a pulse shape filter circuit PlsShpFlt, generating a filtered envelope reference signal rf_lvl. The filtered envelope reference signal rf_lvl is used for generating the envelope shape of the driver supply voltage VDD_RF.

In order to generate the filtered envelope reference signal rf_lvl, the pulse shape filter circuit PlsShpFlt is configured to switch between the first voltage level unmod_lvl and the second voltage level mod_lvl, in conjunction with performing a low-pass filtering of the transitions between the first voltage level unmod_lvl and the second voltage level mod_lvl.

The levels unmod_lvl, mod_lvl, of the filtered envelope reference signal rf_lvl may advantageously be determined by the field strength and modulation depth requirements.

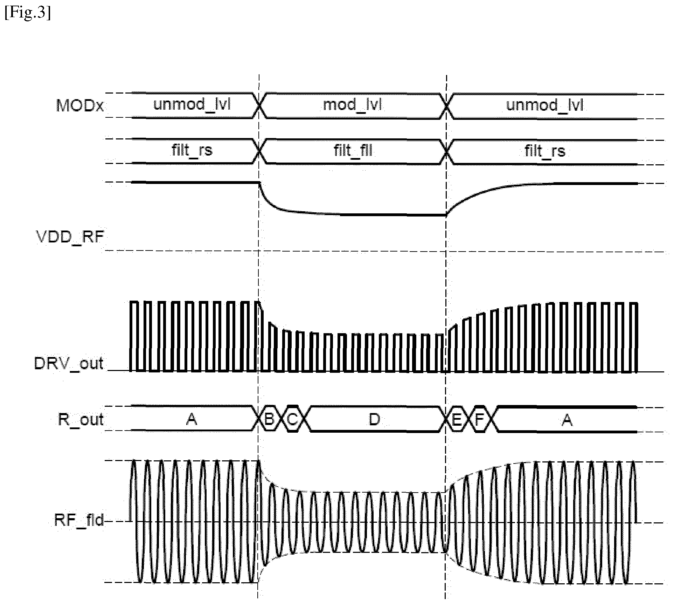

The pulse shape filter circuit PlsShpFlt may advantageously be responsive to control settings Settgs which controls independently a rising time constant filt_rs and a falling time constant filt_fll for the low-pass filtering, as for instance depicted on figure 3.

The rising time constant filt_rs and the falling time constant filt_fll may be determined by the data rate of the transmission and antenna circuit.

The pulse shape filter circuit PlsShpFlt may be implemented in analog, for example with an analog filter with selectable circuits for rising and falling time constants, or implemented in digital, for example with a digital filter with selectable rising and falling time constants and a multi-bit digital-to-analog output.

The pulse shape filter circuit PlsShpFlt may advantageously be adapted to low-pass filter the filtered envelope reference signal rf_lvl to have a monotonic variation until a steady state at the first voltage level unmod_lvl and at the second voltage level mod_lvl, respectively to each transition (as for instance depicted by figure 3, and described hereinafter in relation with figure 3).

The accordingly generated filtered envelope reference signal rf_lvl, may corresponds to the actual level of the driver supply voltage VDD_RF powering the driver circuit DRV.

With regards to this, the wireless transmitter TX includes a regulator circuit RF_reg configured to generate the driver supply voltage VDD_RF following the filtered envelope reference signal rf_lvl, and adapted to supply the driver circuit DRV.

The regulator circuit RF_reg, for instance as described hereinafter in relation with figure 2, provides the driver supply voltage VDD_RF adapted to supply the driver DRV by having for example a low noise, a high bandwidth, a high accuracy and a high efficiency.

As mentioned hereinabove, the driver DRV is then configured to be supplied with the driver supply voltage VDD_RF such that the driver supply voltage VDD_RF controls the envelope shape of the carrier clock signal carr_clk transmitted the output signal DRV_out.

The output signal DRV_out may be directly applied to an antenna circuit (not shown), for conveying strings of digital data according to successive pulses having the unmodulated amplitude or the modulated amplitude.

In addition, the driver circuit DRV may optionally include an output resistance circuit R_out configured to control the output resistance of the driver, for example with the means of several resistant and interval values. The configurable output resistance circuit R_out permits for instance to assist the shaped driver supply voltage VDD_RF with respect to effective load of the antenna circuit.

This example wireless transmitter TX contributes to smooth transitions of the magnetic field generated by the antenna; between the unmodulated and modulated states in all conditions, as depicted on figure 3. The wireless transmitter TX is thus able to easily pass certification, together with providing an improved inter-operability.

Figure 2 illustrates an example of advanced embodiment for the regulator circuit RF_reg, which may be considered as an amplifier circuit configured for low energy consumption.

This advanced regulator circuit RF_reg is capable to provides the driver supply voltage VDD_RF with low noise, high bandwidth, high accuracy and high efficiency.

Additionally, this advanced regulator circuit RF_reg uses a very small external capacitor Cext, for instance about 10 nF (nanofarads) to 100 nF (nanofarads), which may correspond to up to hundred times lower than for conventionnel regulator circuits classically used for generating these modulated and unmodulated voltage levels.

The regulator circuit RF_reg includes an output power stage Pwr_stg configured to drive up and to drive down the driver supply voltage VDD_RF.

For this purpose, the output power stage Pwr_stg includes a first PMOS (which stands for "P-type Metal Oxide Semiconductor" and is perfectly known by the person skilled in the art) transistor P1 configured to drive up, i.e. to actively push up, the output voltage VDD_RF on the output node in a manner controlled by a negative output of an amplifier circuit cmp_amp.

The output stage Pwr_stg also includes a first NMOS (standing for "N-type Metal Oxide Semiconductor") transistor N1 configured to drive down, i.e. to actively pull down, the output voltage VDD_RF on the output node in a manner controlled by a negative output of a amplifier circuit cmp_amp.

The positive output of the amplifier cmp_amp is forwardly responsive the filtered envelope reference signal rf_lvl applied on the positive input, and is inversely responsive to a reference voltage node RefN coupled to the negative input. The negative output of the amplifier cmp_amp has the inverted response.

The reference voltage node RefN is the node in-between the series of two resistors Rd1, Rd2 of a resistive divider circuit, coupled between the output node VDD_RF and the ground GND.

Thus, different output levels can be achieved by varying the resistive divider ratio and/or changing the input voltage level, with respect to the gain of the amplifier cmp_amp.

The regulator circuit RF_reg includes in addition an internal stabilizing circuit including a mirror stage Mirr_stg configured to mirror the output power stage Pwr_stg, and a feedback loop FdLp including a feedback capacitor Cf and a feedback resistor Rf.

The mirror stage Mirr_stg circuit comprises a second PMOS transistor P2 and a second NMOS transistor N2, respectively controlled by the same negative output and positive output of the amplifier cmp_amp as the first MOS transistors P1, N1, and driving up and driving down a feedback node FdN.

The feedback node FdN is coupled on the one hand to the output node VDD_RF through the feedback resistor Rf, and is coupled on the other hand to the reference voltage node RefN through the feedback capacitor Cf. Thus, a drifting current flowing on the output node VDD_RF may be translated in voltage by the feedback resistor Rf on the feedback node FdN, while this translated voltage may be added on the reference voltage node RefN applied on the negative input of the amplifier cmp_amp. Consequently, the output node voltage VDD_RF is back-regulated thanks to the action of the amplifier outputs on the output power stage Pwr_stg.

Turning now to the performances of this advanced embodiment for the regulator circuit RF_reg :
The actively driven output power stage Pwr_stg permits in particular to reduce to zero or almost zero the current losses in short circuit between power supply VDD_TX and ground GND.

Advantageously with this regard, the amplifier circuit cmp_amp may be configured with an output hysteresis such that the positive output and the negative output never control both the first PMOS transistor P1 and the first NMOS transistor N1 in a closed state at the same time.

The actively driven output power stage Pwr_stg also benefits from the high current sinking capabilities of MOS transistors technologies, and is accordingly capable of high-power driver supply voltage VDD_RF output.

The actively driven output power stage Pwr_stg also benefits from the fast response capabilities of the amplifiers and MOS transistors technologies, which permits to generate the driver supply voltage VDD_RF output with a high bandwidth, able to produce the desired modulation pulse shapes.

The major source of noise in the driver supply voltage VDD_RF output comes from resistors Rd1, Rd2 of the resistive divider bridge, and these resistors Rd1, Rd2 can be implemented very small, in order to minimize the noise, since their effect is based on the ratio of the resistive values.

The mirror stage Mirr_stg and feedback loop Rf, Cf, are providing an internal stabilization ensuring a high efficiency, by generating accurate driver supply voltage VDD_RF levels showing low drop-out voltages and stable modulation indexes over the entire output voltage VDD_RF range.

In addition, the internal stabilization permits to remove the need for a large external capacitor, and allows a very small external capacitor Cext of about 10 nF (nanofarads) to 100 nF (nanofarads).

Figure 3 illustrates a time diagram of the implementation of the method for controlling the envelope shape of the output signal DRV_out, and of the contactless magnetic field RF_fld communication, obtained for instance by using the wireless transmitter (TX) described hereinabove in relation with figures 1 and 2.

The method includes supplying MODx a first voltage level unmod_lvl and a second voltage level mod_lvl.

The supply of the first and the second voltage level respectively defines unmodulated pulses and modulated pulses on the envelope shape of the output signal DRV_out, for conveying strings of digital data according to successive unmodulated and modulated amplitudes in the magnetic field RF_fld.

In other words, the first voltage level unmod_lvl sets the level of unmodulated pulses in the output signal DRV_out (and thus sets the amplitude in the magnetic field RF_fld), and the second voltage level mod_lvl sets the level of modulated pulses in the output signal DRV_out (and thus in the amplitude in the magnetic field RF_fld).

The method includes the generation of the filtered envelope reference signal rf_lvl by low-pass filtering the transitions between the first voltage level unmod_lvl and the second voltage level mod_lvl. The transitions between the first voltage level unmod_lvl and the second voltage level mod_lvl may switch according to the data string to be transmitted, as mentioned above.

The low-pass filtering is advantageously adapted so that the filtered envelope reference signal rf_lvl has a monotonic variation until a steady state at the first voltage level unmod_lvl or at the second voltage level mod_lvl respectively to each transition.

For example, the monotonic variation until a steady state means that the filtered envelope reference signal VDD_RF only decreases from the higher level to the lower level (i.e. from the unmodulated level unmod_lvl to the modulated level mod_lvl), and only increases from the lower level to the higher level (i.e. from the modulated level mod_lvl to the unmodulated level unmod_lvl).

More particularly, the filtered envelope reference signal VDD_RF does not increase to surpass over and then decrease to the respective steady state level unmode_lvl, and does neither not decrease to surpass under and then increase to the respective steady state level mod_lvl.

In other words, the filtered envelope reference signal VDD_RF is provided with no overshoot above the higher level unmod_lvl, and with no undershoot below the lower level mod_lvl neither.

In addition, the low pass filtering may be responsive to control settings Settgs which controls independently a rising time constant filt_rs and a falling time constant filt_fll.

For example, the time constants can be determined in order to satisfy the monotonic variation until respective states conditions, while being adapted or adaptable to a desired performance such as the data rate and to a given embodiment such as the antenna circuit.

The example shown illustrates separate rising time constant filt_rs and falling time constant filt_fll.

The method includes generating a driver supply voltage VDD_RF following the filtered envelope reference signal rf_lvl, for example, the driver supply voltage VDD_RF may differ from the filtered envelope reference signal rf_lvl in that the driver supply voltage VDD_RF is regulated in a manner adapted to supply the driver DRV.

With respect to this, regulating the driver supply voltage VDD_RF may include, for instance such as described hereinabove in relation with figure 2, an output powering action Pwr_stg adapted to drive up and to drive down the driver supply voltage VDD_RF, and an internal mirroring action Mirr_stg adapted to reproduce of the output powering action for internal stabilization of the driver supply voltage VDD_RF with a capacitive Cf and resistive Rf feedback looping.

The method includes controlling the envelope shape of the output signal DRV_out by supplying the driver DRV with the driver supply voltage VDD_RF.

The driver supply voltage VDD_RF accordingly modulates the amplitude of a carrier clock signal carr_clk supporting the output signal DRV_out.

Optionally, the driver output resistance R_out can also be used to assist the shaped driver supply voltage VDD_RF. Several output resistance R_out values A, B, C, D, E, F may vary over interval values for example from an output resistance R_out values A adapted for the unmodulated state, switching to an output resistance R_out values D adapted for the modulated value, via intermediate output resistance R_out values B and C, and then switching back to the output resistance R_out values A adapted for the unmodulated value, via intermediate output resistance R_out values E and F.

All of the above contribute to smooth transitions of the magnetic field RF_fld between the unmodulated and modulated states in all conditions, so it become much easier to pass certification and provide improved interoperability.

The invention is not limited to the above described embodiments.

More particularly, as indicated above, the pulse shape filter circuit PlsShpFlt may be implemented in analog, for example with an analog filter, or implemented in digital, for example with a digital filter.

But, when implemented in analog, it is possible to use only one time constant for falling and rising edges. In other words, in such a case, the rising time constant filt_rs and the falling time constant filt_fll are equal. And the settings Settgs (figure 1) are used to give the value of this time constant.

## Claims

1. Method for controlling an envelope shape of an output signal (DRV_out) outputted by a driver (DRV) of a wireless transmitter (TX), including:
- supplying a first voltage level (unmod_lvl) and a second voltage level (mod_lvl);
- generating a filtered envelope reference signal (rf_lvl) by switching between the first voltage level (unmod_lvl) and the second voltage level (mod_lvl), in conjunction with low-pass filtering the transitions between the first voltage level (unmod_lvl) and the second voltage level (mod_lvl);
- generating a driver supply voltage (VDD_RF) following the filtered envelope reference signal (rf_lvl), regulated in a manner adapted to supply the driver (DRV);
- controlling the envelope shape of the output signal (DRV_out) by supplying the driver (DRV) with the driver supply voltage (VDD_RF).

2. Method according to claim 1, wherein the first voltage level (unmod_lvl) sets the level of unmodulated pulses in the output signal (DRV_out), and the second voltage level (mod_lvl) sets the level of modulated pulses in the output signal (DRV_out).

3. Method according to any of claims 1 or 2, wherein the low-pass filtering is adapted so that the filtered envelope reference signal (rf_lvl) has a monotonic variation until a steady state at the first voltage level (unmod_lvl) or at the second voltage level (mod_lvl) respectively to each transition.

4. Method according to any of claims 1 to 3, wherein the low pass filtering is responsive to control settings which controls independently a rising time constant (filt_rs) and a falling time constant (filt_fll).

5. Method according to any one of claims 1 to 3, wherein the low pass filtering is an analog low pass filtering using a rising time constant (filt_rs) equal to a falling time constant (filt_fll).

6. Method according to any of claims 1 to 5, wherein regulating the driver supply voltage (VDD_RF) includes an output powering action (Pwr_stg) adapted to drive up and to drive down the driver supply voltage (VDD_RF), and an internal mirroring action (Mirr_stg) adapted to reproduce of the output powering action for internal stabilization of the driver supply voltage (VDD_RF) with a capacitive (Cf) and resistive (Rf) feedback looping.

7. Wireless transmitter (TX) including:
- a driver (DRV) configured to output an output signal (DRV_out) with a controlled envelope shape;
- supplying circuits configured to supply a first voltage level (unmod_lvl) and a second voltage level (mod_lvl);
- a pulse shape filter circuit (PlsShpFlt) which, in order to generate a filtered envelope reference signal (rf_lvl), is configured to switch between the first voltage level (unmod_lvl) and the second voltage level (mod_lvl), in conjunction with to low-pass filter the transitions between the first voltage level (unmod_lvl) and the second voltage level (mod_lvl);
- a regulator circuit (RF_reg) configured to generate a driver supply voltage (VDD_RF) following the filtered envelope reference signal (rf_lvl) and adapted to supply the driver (DRV);
- the driver (DRV) being configured to be supplied with the driver supply voltage (VDD_RF) such that the driver supply voltage (VDD_RF) controls the envelope shape of the output signal (DRV_out).

8. Wireless transmitter according to claim 7, wherein the driver (DRV) is configured to output unmodulated pulses in the output signal (DRV_out) having a level set by the first voltage level (unmod_lvl), and to output modulated pulses in the output signal (DRV_out) having a level set by the second voltage level (mod_lvl).

9. Wireless transmitter according to any of claims 7 or 8, wherein the pulse shape filter circuit (PlsShpFlt) is adapted to low-pass filter the filtered envelope reference signal (rf_lvl) to have a monotonic variation until a steady state at the first voltage level (unmod_lvl) and at the second voltage level (mod_lvl), respectively to each transition.

10. Wireless transmitter according to any of claims 7 to 9, wherein the pulse shape filter circuit (PlsShpFlt) is responsive to control settings which controls independently a rising time constant (filt_rs) and a falling time constant (filt_fll) for the low-pass filtering.

11. Wireless transmitter according to any of claims 7 to 9, wherein the pulse shape filter circuit (PlsShpFlt) includes an analog low pass filter having a rising time constant (filt_rs) equal to a falling time constant (filt_fll).

12. Wireless transmitter according to any of claims 7 to 11, wherein the regulator circuit (RF_reg) includes an output power stage (Pwr_stg) configured to drive up and to drive down the driver supply voltage (VDD_RF), and an internal stabilizing circuit including a mirror stage (Mirr_stg) configured to mirror the output power stage, and a capacitive (Cf) and resistive (Rf) feedback loop.
